Europäisches Patentamt

European Patent Office

Office européen des brevets

(11) Publication number: **0 045 482**
**B1**

# EUROPEAN PATENT SPECIFICATION

(45) Date of publication of patent specification: **30.10.85**

(51) Int. Cl.⁴: **H 01 L 27/01,** H 01 B 1/16

(21) Application number: **81105970.8**

(22) Date of filing: **29.07.81**

(54) Thick film conductor compositions.

(30) Priority: **31.07.80 US 174257**

(43) Date of publication of application:
**10.02.82 Bulletin 82/06**

(45) Publication of the grant of the patent:
**30.10.85 Bulletin 85/44**

(84) Designated Contracting States:
**BE DE FR GB IT LU NL**

(56) References cited:
**FR-A-2 160 070**
**FR-A-2 309 020**
**FR-A-2 383 507**

**CHEMICAL ABSTRACTS, vol. 86, 1977, page
665, abstract 149590a Columbus, Ohio, US**

(73) Proprietor: **E.I. DU PONT DE NEMOURS AND
COMPANY
1007 Market Street
Wilmington Delaware 19898 (US)**

(72) Inventor: **Taylor, Barry Edward
343 Howard Drive Collingwood Estates
Youngstown New York 14174 (US)**

(74) Representative: **Werner, Hans-Karsten, Dr. et al
Deichmannhaus am Hauptbahnhof
D-5000 Köln 1 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

### Field of the invention

The invention is related to thick film conductor compositions and particularly to thick film conductor compositions containing noble metals.

### Background of the invention

Thick film conductors are widely used as a means of interconnecting various passive and active devices for hybrid microcircuits and resistor networks. Utility as a general purpose conductor requires certain performance attributes such as conductivity, solderability, solder leach resistance, compatibility with other circuit components and ability to be processed under a wide range of conditions. Inherent in the usefulness of thick film conductors is the cost of materials which comprise the composition. It is extremely advantageous to reduce the cost without significantly changing the performance characteristics.

The use of nickel metal or alloys containing nickel is of significant importance due to the high cost of precious metals such as palladium, platinum, gold, and silver. The problem generally encountered with nickel-containing thick film compositions is that they generally are oxidized at high firing temperature (greater than 600°C) and consequently are difficult to solder.

### Description of the prior art

Various attempts to surface-coat nickel metal or nickel alloy powders have been made using (1) glass or nonconductive oxidation-resistant coatings (2) precious metal coatings, and (3) protective conductive coatings such as metal borides, silicides or carbides. A fourth approach has been to use additives such as boron which preferentially oxidize and convert to glass-like structures during the firing cycle. The following discussion will illustrate the problems and deficiencies of each of these techniques.

Use of oxidation-resistant borate coatings on nickel and nickel-tin-zinc metal powders is disclosed in U.S. 4,130,854. The coatings are added by an aqueous treatment of the metal powders. Reportedly, the nickel-zinc-tin metallizations can be used as direct replacement for silver with no adverse effect on performance. However, as described in the patent, the fired metallizations apparently cannot be soldered directly without a premetallization technique. Such techniques are costly and undesirable in most high volume microcircuit applications.

Another technique used to lower the overall amount of precious metal in thick film conductors and resistors is described in U.S. 3,846,345. A dielectric core such as glass, alumina or beryllia is overcoated with non-noble metals such as nickel and copper, and then coated with precious metal which is resistant to oxidation. U.S. 3,718,608 and U.S. 3,598,761 provide examples of variations which can be used to make gold-coated nickel particles. The disadvantage of such multiple-coating processes is their complexity. Therefore, for large volume applications the cost is usually high and the reproducibility is poor.

Metal carbide, silicide or boride conductive coatings on metal powders are described in U.S. 4,137,361. These protective coatings are intended to afford protection of the metal particles only under ambient conditions. Therefore, their performance under high temperature firing conditions in highly oxidizing atmospheres is unknown.

Addition of boron to air-fireable base metal conductors is discussed in U.S. 4,122,232. In this case, boron is a paste additive which undergoes preferential oxidation and therefore protects the base metal from oxidation.

However, the oxidation-resistant properties of Ni-B compositions are due to formation of $B_2O_3$ during firing. Since boron oxide is adversely affected by moisture, the fired conductor film can be degraded by high humidity conditions.

U.S. 4,079,156 illustrates use of carbon, boron, silicon, aluminum, carbon-silicon and boron-silicon to give similar preferential oxidation with base metal compositions. The oxidizable additions in this case are alloyed with nickel or copper to give a uniform solid dispersion. When the intimately mixed alloy is fired in air, the additives are oxidized, forming a protective coating on the base metal.

U.S. 4,070,517 also describes various alloy combinations of nickel-boron, aluminum-boron, copper-boron, and aluminum-nickel-boron alloys which can achieve a high level of conductivity when employed in thick film compositions. Although the conductivity of such compositions fulfills the necessary requirements for typical thick film materials, these alloys when fired in air do not give easily solderable surfaces and therefore would require an over-coating or premetallization process to provide a solderable surface. As mentioned earlier, such techniques are cumbersome and costly when circuits are manufactured in high volume.

Direct use of nickel metal in metallizations containing palladium, gold, silver, and platinum is described in U.S. 3,872,360. It is stated that 90% of the metal particles should be less than 50 µm in size and that fine particle nickel facilitates sintering and any reactions that occur. The beneficial role of nickel as a diluent to retard sintering of palladium is illustrated with respect to performance on dielectrics. However, it is pointed out that oxidation of nickel to form nickel oxide does occur, and the fired electrodes show no functional interaction between the palladium and nickel.

### Brief description of the invention

The invention is directed to a thick film conductor composition comprising a mixture of finely divided noble metal(s) nickel and other components, the mixture being characterized by a content of a glassy inorganic binder and up to 55% by weight, the basis being total metals, of finely divided spheroidal nickel metal particles having a surface/weight ratio of below 0.35 m²/gram.

In a further aspect, the invention is directed to screen-printable formulations of the above mixtures and in a still further aspect the invention is directed to thick film conductors prepared from the above-described compositions.

## Detailed description of the invention

### A. Nickel particles

The nickel powders which are suitable for the compositions of the invention are spheroidal in morphology and have a ratio of surface area to weight of less than 0.35 m²/g. As used herein, the term spheroidal includes spheres, spheroids, and even irregular shapes so long as they have a surface/weight ratio of less than 0.35 m²/g and preferably 0.2 or below.

For most effective use in thick film conductors, the nickel particles should be within certain limits of size. In particular, at least 90% by weight should have a mean diameter below 20 μm and above 5μm. Smaller particles of nickel tend to incur excessive oxidation with resultant degradation of conductivity and solderability upon high temperature firing. On the other hand, if the nickel particles exceed the upper limit, clogging of the printing screens is likely to occur, especially when fine screens, e.g., 325 mesh, are used.

Although coarse nickel powders cause excessive surface roughness and generally lead to unacceptable performance in microcircuit applications, those familiar with the art of screen printing will realize that the use of coarse screens would make coarser nickel powders acceptable in certain applications where surface roughness is not important. A mean particle diameter of 9—15 μm and especially 12 μm is preferred for optimum printing properties.

### B. Binder

Glasses and other inorganic binders used in conductors perform several functions. For example, they facilitate sintering of the metal film by means of liquid phase sintering; therefore the glassy binder must wet the metal surface. They also provide a chemical and/or mechanical bond to the substrate material by flowing and wetting the substrate and chemically reacting with it. This mechanical/chemical bond provides the means by which the conductor film adheres to the substrate. Transition metal oxides such as NiO, ZnO and CuO when used in combination with a suitable glass react with alumina substrates and form compounds such as $CuAl_2O_4$, $NiAl_2O_4$ and $ZnAl_2O_4$ spinels.

Bismuthate glasses are used in typical microcircuit conductor compositions to promote solderability. Therefore bismuth oxide-containing glasses are preferably used where solderability is an important criterion. An example of a binder of this type is an admixture of $Bi_2O_3$, $ZnCO_3$, $Cu_{.5}Bi_{1.5}Ru_2O_{6.75}$ and an experimental glass (a copper-based lead aluminoborosilicate), which gives the fired conductor films excellent adhesion to alumina. Other suitable glassy inorganic materials are reactive metal oxides such Bi/Cu, Cd/Pb, Cd/Cu and Cd/Pb/Bi, which tend to be desirably low melting.

Although the chemical composition of the binder system is not critical to the functionality of spherical nickel powders in thick film conductor compositions, the inorganic binder should melt or flow at a sufficiently low temperature partially to encapsulate the metal particles during sintering and hence further reduce oxidation.

### C. Vehicle

Any inert liquid may be used as the vehicle. Water or any one of various organic liquids, with or without thickening and/or stabilizing agents and/or other common additives, may be used as the vehicle. Exemplary of the organic liquids which can be used are the aliphatic alcohols; esters of such alcohols, for example, the acetates and propionates; terpenes such as pine oil, terpineol and the like; solutions of resins such as the polymethacrylates of lower alcohols, or solutions of ethyl cellulose in solvents such as pine oil and the monobutyl ether of ethylene glycol monoacetate. The vehicle may contain or be comprised of volatile liquids to promote fast setting after application to the substrate.

The ratio of inert liquid vehicle to solids in the metallizing compositions of this invention can vary considerably and depends upon the manner in which the dispersion of metallizing composition in vehicle is to be applied and the kind of vehicle used. Generally, from 0.5 to 20 parts by weight of solids per part by weight of vehicle will be used to produce a dispersion of the desired consistency. Preferred dispersions contain 30—70% vehicle, and, still more preferably, 40—60% vehicle.

### D. Formulation

The compositions of the present invention comprise finely divided inorganic and precious metal powders dispersed in inert vehicles. The powders are sufficiently finely divided to be used in conventional screen or stencil printing operations and to facilitate sintering. Generally, 90% or more (by weight) of the particles other than nickel are less than 5 microns. In optimum metallizations substantially all of the precious metal particles are less than 1 micron in size. The optimum surface area is therefore greater than 0.5 m²/gram.

Precious metal powders such as silver, palladium, platinum and gold are necessary in these compositions to give the desired conductor performance, such as solderability and conductivity. In applications where solderability is not important, lower levels of the precious metals can be used. To obtain resistivities lower than 100—200 milliohms/square in palladium silver conductors, for example, the ratio of nickel to total metal should not exceed 4/7.

The metallizing compositions are prepared from the solids and vehicles by mechanical mixing. Optimum dispersion can be obtained with a three roll mill at operating pressures of 3,5—21,1 kg/cm$^2$ (50—300 psi). The mixture of solids and vehicles is passed through the mill until a uniform dispersion is obtained.

E. Sample preparation and test procedures

The examples hereinbelow describe specific metallurgies of the invention with a glass binder system which yields high adhesion to $Al_2O_3$ substrates. All adhesion, conductivity, solderability and solder leach resistance testing was performed on metallizations processed by heating them at a rate of 50—100°C per minute to 850°C, holding at 850°C for about 10 minutes and cooling at a rate of 50—100°C per minute to room temperature. Parts were fired one to three times using this firing cycle to demonstrate sensitivity of repeated firings. Adhesion and conductivity data are shown for parts fired 3×850°C, whereas solder leach resistance tests were performed on parts fired once at 850°C.

The solder leach resistance tests were performed as follows: The fired parts were dipped in a mildly active flux such as Alpha 611, then heated for 5 seconds by dipping the edge of the ceramic chip in the molten solder. The chip was then submerged in the solder for 10 seconds, then withdrawn, cleaned, and inspected. Failure was determined by the number of dips necessary to cause a break in a 0,5 mm (20 mil) wide serpentine conductor line.

The adhesion was measured using an "Instron" pull tester in a 90° peel configuration at a pull rate of 5,1 cm/min (2 inches per minute). Twenty gauge pre-tinned wires were attached to 2,0 mm×2,0 mm (80 mil×80 mil) pads by solder dipping for 10 seconds in 62 Sn/36 Pb/2 Ag solder at 220°C or in 63 Sn/37 Pb solder at 230°C using Alpha 611 flux. Aging studies were carried out in a Blue M Stabil-Therm® oven controlled at 150°C. After aging, test parts were allowed to equilibrate several hours in air before the wires were pulled.

Those skilled in the art will realize that the invention is not dependent upon a specific firing temperature (e.g., 850°C), nor on a specific substrate type (e.g., $Al_2O_3$). Therefore, although the metallizations were developed for microcircuit applications, they could advantageously be used as inner electrodes for barium titanate multilayer capacitors which require firing temperatures of 1200—1300°C. With a slight modification of the inorganic binder, they also could be used on porcelainized steel substrates at firing temperatures of 550—650°C. Yet another application would be for demister compositions as a cheap replacement for silver metal.

In the following examples, four different glass compositions were used. These are described in Table I below.

TABLE I
Glass compositions

| Glass A | | Glass B | |
|---|---|---|---|
| $Bi_2O_3$ | 75.1% | PbO | 42.5% |
| PbO | 10.9% | $SiO_2$ | 36.6% |
| $SiO_2$ | 9.3% | $B_2O_3$ | 4.7% |
| CaO | 2.4% | $Al_2O_3$ | 4.3% |
| $B_2O_3$ | 1.3% | CaO | 9.6% |
| $Al_2O_3$ | 1.0% | CuO | 2.3% |
| Glass C | | Glass D | |
| PbO | 41.9% | CdO | 68.80% |
| $SiO_2$ | 36.0 | $B_2O_3$ | 18.60 |
| $B_2O_3$ | 4.7 | $SiO_2$ | 9.50 |
| $Al_2O_3$ | 4.2 | $Al_2O_3$ | 3.10 |
| CaO | 9.4 | | |
| CuO | 3.8 | | |

4

Furthermore, several different binder compositions were used in carrying out the below-described examples. These binders are listed in Table II immediately following:

TABLE II
Glass compositions

| Binder A | | Binder B | | Binder C | |
|---|---|---|---|---|---|
| $Bi_2O_3$ | 12% | Glass A | 12% | Glass A | 12% |
| $Cu_2O$ | 1% | $Cu_2O$ | 1% | $ZnCO_3$ | 1% |

| Binder D | | Binder E | |
|---|---|---|---|
| Glass B | 3% | Glass C | 3% |
| $Bi_2O_3$ | 4.4% | $Bi_2O_3$ | 4.4% |
| $Cu_{0.5}B_{1.5}Ru_2O_{6.75}$ | 2.2% | $Cu_{0.5}Bi_{1.5}Ru_2O_{6.75}$ | 2.2% |
| $ZnCO_3$ | 1.0% | $ZnCO_3$ | 1.0% |

| Binder F | | Binder G | | Binder H | |
|---|---|---|---|---|---|
| CdO | .6% | Glass A | 10% | Glass A | 16% |
| $Bi_2O_3$ | 2.2% | $Co_3O_4$ | .5% | $Cu_2O$ | .1% |
| $ZnCO_3$ | .1% | | | | |

| Binder I | | Binder J | |
|---|---|---|---|
| $Bi_2O_3$ | .4% | $Bi_2O_3$ | 1.0% |
| $Cu_2O$ | .1% | CdO | .75% |
| Glass D | .5% | $Cu_2O$ | .25% |

The binder systems listed in Table II range from simple systems containing bismuth and copper oxides, to more complex mixed bonded systems containing a bismuthate glass and transition metal oxide. The exact chemistry of the binder is primarily important in that it should give high adhesion to the substrate material and should allow easy solderability over a range of soldering conditions.

Examples 1—8

Examples 1 through 8, which are described in Table III, demonstrate the general utility of nickel metal in compositions containing several different binder types. Comparison of Control A with Examples 2, 7 and 8 shows that aged adhesion and solder leach resistance of nickel-containing compositions is equal to or better than those containing no nickel. The nickel particles had a surface-to-weight ratio of about 0.20 and a mean particle diameter of 12 µm.

**0 045 482**

TABLE III

| Example No. | Metal content (% wt) | Binder type (%) | SLR[1] | Aged adhesion[2] (kg)/(LBS) | Aging time (HRS) |
|---|---|---|---|---|---|
| Control A | 63% Ag/5% Pd | A (13%) | 7—8/220°C | 0.91/2.0[3] | 48 |
| 1 | 61% Ag/2% Ni/5% Pd | A (13%) | 7—8/220°C | 1.54/3.4[3] | 48 |
| 2 | 59% Ag/4% Ni/5% | A (13%) | 7—8/220°C | 1.50/3.3[3] | 48 |
| 3 | 61% Ag/2% Ni/5% Pd | B (13%) | 7—8/220°C | 2.22/4.9[3] | 48 |
| 4 | 59% Ag/4% Ni/5% Pd | C (13%) | 7—8/220°C | 2.45/5.4 2.36/5.2 | 48 1000 |
| 5 | 61% Ag/2% Ni/5% Pd | C (13%) | 7—8/220°C | 2.58/5.7 2.36/5.2 | 48 1000 |
| 6 | 60% Ag/3% Ni/5% Pd | C (13) | 7—8/220°C | 2.77/6.1 2.49/5.5 | 48 1000 |
| 7 | 63% Ag/4% Ni/5% Pd | D (11%) | 8—10/220°C | 2.81/6.2 2.31/5.1 | 48 1000 |
| 8 | 63% Ag/4% Ni/5% Pd | E (11%) | 8—10/220°C | 2.81/6.2 2.40/5.3 | 48 1000 |

[1] SLR=Solder Leach Resistance: No. of 10 second dips/solder temperature, for 62 Sn/36 Pb/2 Ag solder unless indicated otherwise

[2] Aging Temperature=150°C, solder=62 Sn/36 Pb/2 Ag unless indicated otherwise, 2,0 mm×2,0 mm (80 mil×80 mil) pads

[3] 63 Sn/37 Pb solder, Aging Temperature=150°C

TABLE IV

| Example No. | Metal content (% wt) | Binder type (%) | SLR[1] | Aged adhesion[3] (kg)/(LBS) | Aging time (HRS) | Resist- tivity mohms/□ |
|---|---|---|---|---|---|---|
| 9 | 75.5% Ag/4% Ni/5.2% Pd | F (3.00%) | 10/220°C | × | × | 4 |
| 10 | 60% Ag/5% Ni/5% Pd | E (11%) | 2—3/230°C | × | × | 10 |
| 11 | 45% Ag/20% Ni/5% Pd | E (11%) | 1—2/230°C | × | × | 25 |
| 12 | 25% Ag/40% Ni/5% Pd | E (11%) | 0/230°C | × | × | 275 |
| Control B | 50% Ag/9% Pt/4% Pd | G (10.5) | 8—10/220°C | 2.77/6.1 2.45/5.4 | 48 600 | 38 |
| 13 | 50% Ag/6.7% Pt/4% Pd/ 3% Ni | G (10.5) | 8—10/220°C | 2.81/6.2 2.58/5.7 | 48 600 | 37 |
| 14 | 50% Ag/4.5% Pt/4% Pd/ 4.5% Ni | G (10.5) | 8—10/220°C | 2.68/5.9 2.58/5.7 | 48 600 | 33 |
| Control C | 40 Ag/11% Pt/11% Pd/ | H (16%) | >10/240°C[2] | 2.36/5.2 2.49/5.5 | 48 1000 | 67 |
| 15 | 40% Ag/8.3% Pt/11% Pd/ 2.7% Ni | H (16%) | >10/240°C[2] | 2.09/4.6 2.00/4.4 | 48 1000 | 61 |
| 16 | 40% Ag/5.5% Pt/11% Pd/ 5.5% Ni | H (16%) | 7—8/240°C$^2$ | 2.27/5.0 2.27/5.0 | 48 1000 | 53 |
| 17 | 40% Ag/11% Pt/8.3% Pd/ 2.7% Ni | H (16%) | >10/240°C$^2$ | 2.18/4.8 2.27/5.0 | 48 1000 | 76 |
| 18 | 40% Ag/11% Pt/5.5% Pd/ 5.5% Ni | H (16)% | 7—8/240°C$^2$ | 2.00/4.4 2.09/4.6 | 48 1000 | 77 |

[1] SLR—Solder Leach Resistance, No. of 10 second dips/temperature of solder, for 62 Sn/36 Pb/2 Ag solder unless indicated otherwise

[2] 63 Sn/37 Pb solder

[3] Aging Temperature=150°C, solder=62 Sn/36 Pb/2 Ag unless indicated otherwise, 2,0 mm×2,0 mm (80 mil×80 mil) pads

Examples 9—18

Example 9 (Table IV) shows that low binder levels do not adversely affect solder leach resistance or conductivity. The amount of nickel was varied from 5% to 40% in Examples 10, 11, and 12 (Table IV). Although a noticeable degradation of solderability and solder leach resistance is observed, the resistivity showed a monotonic increase as one would expect with substitutions of a less conductive metal (nickel) for a more conductive one (silver). In applications where solderability is not important or where a solderable connection could be overprinted on top of the nickel-bearing conductor, even higher nickel concentrations could be used.

Control B and Examples 13 and 14 (Table IV) illustrate how nickel can be substituted for platinum metal without significantly altering the performance. In fact higher nickel concentrations give higher conductivity because of the inherently higher conductivity of nickel versus platinum. Solder leach resistance and aged adhesion are basically unchanged.

Similarly, Control C and Examples 15—18 (Table IV) demonstrate the substitution of nickel for platinum and palladium. Up to 25% of the precious metal content can be replaced with nickel with little degradation in solder leach resistance or adhesion. When 50% of the precious metal is replaced by nickel, somewhat lower aged adhesion values and solder leach resistance are observed.

Examples 19 and 20

Examples 19 and 20 and Control D shown in Table V demonstrate the substitution of nickel for gold. Because the conductivity of nickel is much lower than gold, a twofold increase in resistance is observed with only 2% nickel substitution. Although higher nickel concentrations could be substituted, they would lead to unacceptably high resistivity in many applications where pure gold compositions are used.

TABLE V

| Example No. | Metal content | Binder type (%) | Adhesion (kg)/(LBS) | Resistivity[1] m Ω/□/mil |
|---|---|---|---|---|
| 19 | 82% Au/1% Ni | I (2%) | 2.49/5.5 | 2.0 |
| 20 | 82% Au/2% Ni | I (2%) | 2.49/5.5 | 2.5 |
| Control D | 83% Au | J (2%) | 2.49/5.5 | 1.1 |

[1] Initial adhesion values after 24 hours at room temperature, solder=50 Pb/50 In, 2,0 mm×2,0 mm (80 mil×80 mil) pads

## Claims

1. A thick film conductor composition comprising a mixture of finely divided particles of noble metals, nickel, and other components, the mixture being characterized by a content of
a) a glassy inorganic binder and
b) up to 55% by weight, basis total metals, of spheroidal nickel particles having a surface/weight ratio below 0.35 m²/g.

2. The composition of claim 1 in which the surface/weight ratio of the nickel particles is below 0.2 m²/gm.

3. The composition of claim 1 in which at least 90% by weight of the nickel particles have a mean diameter between 5 and 20 μm.

4. The composition of claim 1 in which at least 90% by weight of the noble metal particles have a mean diameter below 5 μm.

5. A screen-printable thick film conductor composition comprising the compositions of any of claims 1—4 dispersed in an inert vehicle.

6. A conductive layer comprising a thick film of the composition of claim 5 which has been fired to remove the inert vehicle and to effect sintering of the glassing inorganic binder.

## Patentansprüche

1. Dickfilm-Leiter-Zusammensetzung aus einer Mischung aus feinteiligen Teilchen aus Edelmetallen, Nickel und anderen Komponenten, gekennzeichnet durch einen Gehalt an
a) einen glasigen anorganischen Bindemittel und
b) bis zu 55 Gew.-%, bezogen auf die Gesamtmenge der Metalle, kugelförmigen Nickel-Teilchen mit einem Verhältnis Oberfläche/Gewicht unterhalb von 0,35 m²/g.

2. Zusammensetzung nach Anspruch 1, gekennzeichnet durch ein Verhältnis Oberfläche/Gewicht der Nickel-Teilchen unterhalb von 0,2 m²/g.

3. Zusammensetzung nach Anspruch 1, dadurch gekennzeichnet, daß die Nickel-Teilchen zu wenigstens 90 Gew.-% einen mittleren Durchmesser zwischen 5 und 20 µm haben.

4. Zusammensetzung nach Anspruch 1, dadurch gekennzeichnet, daß die Edelmetall-Teilchen zu wenigstens 90 Gew.-% einen mittleren Durchmesser unterhalb von 5 µm haben.

5. Siebdruckfähige Dickfilm-Leiter-Zusammensetzung, enthaltend eine Zusammensetzung nach irgendeinem der Ansprüche 1 bis 4 dispergiert in einem inerten Träger.

6. Leitfähig Schicht aus einem dicken Film der Zusammensetzung nach Anspruch 5, der zur Entfernung des inerten Trägers und zur Bewirkung des Sinterns des glasigen anorganischen Bindemittels gebrannt ist.

**Revendications**

1. Une composition pour conducteurs en film épais, qui comprend un mélange de particules finement divisées de métaux nobles, de nickel, et d'autres constituants, le mélange étant caractérisé par une teneur de

a) un liant minéral vitreux, et

b) jusqu'à 55% en poids, sur la base des métaux totaux, de particules de nickel sphéroïdales ayant un rapport surface/poids inférieur à 0,35 m²/g.

2. La composition de la revendication 1, dans laquelle le rapport surface/poids des particules de nickel est inférieur à 0,2 m²/g.

3. La composition de la revendication 1, dans laquelle au moins 90% en poids des particules de nickel ont un diamètre moyen compris entre 5 et 20 µm.

4. La composition de la revendication 1, dans laquelle au moins 90% en poids des particules de nickel ont un diamètre moyen inférieur à 5 µm.

5. Une composition pour conducteurs en film épais, applicable par impression sérigraphique, comprenant une composition selon l'une quelconque des revendications 1 à 4 dispersée dans un véhicule inerte.

6. Une couche conductrice comprenant un fil épais de la composition de la revendication 5 qui a été cuit pour éliminer le véhicule inerte et pour effectuer le frittage du liant minéral vitreux.